# EUROPÄISCHE PATENTSCHRIFT

(11) **EP 3 698 075 B1**
(45) Veröffentlichungstag und Bekanntmachung des Hinweises auf die Patenterteilung: **01.03.2023**
(21) Anmeldenummer: 18768860.1
(22) Anmeldetag: 10.09.2018
(51) Int. Cl.: F16L 27/08, G01N 33/00, G01M 15/10, H05K 5/00, G01N 1/22

(54) **STEUERSCHRANK**
CONTROL CABINET
ARMOIRE DE COMMANDE

(30) Priorität: 17.10.2017 DE 102017124152
(43) Veröffentlichungstag der Anmeldung: 26.08.2020
(73) Patentinhaber: AVL Emission Test Systems GmbH, 41460 Neuss (DE)
(72) Erfinder: WILLICH, Sascha, 41352 Korschenbroich (DE); GARTHE, Christopher, 41564 Kaarst (DE); OPITZ, Sonja, 40472 Düsseldorf (DE)
(74) Vertreter: terpatent Patentanwälte ter Smitten Eberlein-Van Hoof Rütten Daubert
(86) Internationale Anmeldenummer: PCT/EP2018/074313
(87) Internationale Veröffentlichungsnummer: WO 2019/076538

(56) Entgegenhaltungen:
- EP-A1- 2 317 833
- DE-A1- 2 733 571
- DE-U1- 8 808 477

## Beschreibung

Die Erfindung betrifft einen Steuerschrank für eine Abgasmessanlage mit einem Schrankkörper, in dem eine Komponente der Abgasmessanlage mit einem innenhalb des Schrankkörpers angeordneten Einlass und einem innerhalb des Schrankkörpers angeordneten Auslass angeordnet ist, wobei der Auslass über ein erstes Anschlusselement mit einem Auslassrohr und der Einlass über ein zweites Anschlusselement mit einem Einlassrohr verbunden sind, wobei das erste oder das zweite Anschlusselement wahlweise in einer ersten Anschlussstellung oder in einer zweiten Anschlussstellung montierbar ist, derart, dass das an das erste oder zweite Anschlusselement anschließende Auslassrohr oder Einlassrohr in der ersten Anschlussstellung horizontal und in der zweiten Anschlussstellung vertikal ausgerichtet ist.

Derartige Abgasmessanlagen werden beispielsweise zum Bestimmen des Emissionsverhaltens von Kraftfahrzeugen eingesetzt, wobei auf einem Rollenprüfstand ein vordefinierter Fahrzyklus nachgefahren wird und die dabei ausgestoßenen Abgase bezüglich der im Abgas enthaltenen Schadstoffe analysiert werden. Dabei werden insbesondere der Kohlendioxid-, der Kohlenmonoxid-, Kohlenwasserstoff- sowie der Stickoxid-Anteil ermittelt. Die Abgasmessanlage weist üblicherweise ein Abgasverdünnungssystem auf.

Üblicherweise sind die einzelnen Komponenten der Abgasmessanlage in mehreren Steuerschränken angeordnet. Dabei werden bestimmte, in den Schaltschränken angeordnete Komponenten der Abgasmessanlagen mit dem Abgas durchströmt, so dass diese Komponenten einen Einlass und einen Auslass aufweisen. An dem Auslass ist ein Auslassrohr und an dem Einlass ist ein Einlassrohr zum Steuerschrank angeschlossen, wobei die Lage und die Ausrichtung des Einlassrohrs und insbesondere des Auslassrohrs bereits vor dem Aufstellen des Steuerschranks vom Kunden vorgegeben sind, so dass der Steuerschrank an diese Vorgaben angepasst werden muss.

Die EP 2 317 833 A1 offenbart einen Steuerschrank, wobei in dem Steuerschrank eine Komponente einer Abgasmessanlage angeordnet ist. Die Komponente weist einen Einlass und zwei Auslässe auf, wobei der Einlass im oberen Bereich des Steuerschranks angeordnet ist und über ein durch ein Deckenelement des Steuerschranks verlaufendes erstes Anschlusselement mit einem Einlassrohr verbunden ist. Die beiden Auslässe sind im unteren Bereich des Steuerschranks angeordnet und können über ein zweites Anschlusselement mit einem Auslassrohr verbunden werden. Je nach Lage und Ausrichtung des Auslassrohrs werden unterschiedliche Anschlusselemente für die erste Anschlussstellung und die zweite Anschlussstellung benötigt, wobei das zweite Anschlusselement in der ersten Anschlussstellung an dem ersten Auslass und in der zweiten Anschlussstellung an dem zweiten Auslass montiert wird.

In der ersten Anschlussstellung durchdringt das zweite Anschlusselement eine Seitenwand des Steuerschranks, so dass ein horizontal verlaufendes Auslassrohr über das zweite Anschlusselement mit dem ersten Auslass verbunden wird. In der zweiten Anschlussstellung durchdringt das zweite Anschlusselement ein Bodenelement des Steuerschranks, so dass ein vertikal verlaufendes und unterhalb des Steuerschranks angeordnetes Auslassrohr über das alternative zweite Anschlusselement mit dem zweiten Auslass verbunden wird.

Nachteilig an dem in der EP 2 317 833 A1 beschriebenen Steuerschrank ist, dass für das Verbinden des Auslasses mit dem Auslassrohr, dessen Lage und Ausrichtung bereits vor dem Aufstellen des Steuerschranks vorgegeben sind, mehrere Auslässe mit verschiedenen Anschlusselementen vorgesehen werden und dadurch der Herstellungs- sowie der Montageaufwand erhöht werden.

Die Aufgabe der Erfindung ist es daher, einen Steuerschrank für eine Abgasmessanlage bereitzustellen, welcher unabhängig von der Lage und der Ausrichtung des Auslassrohrs oder des Einlassrohrs aufgestellt werden kann, wobei hierfür die Verbindung zwischen dem Auslass und dem Auslassrohr bzw. die Verbindung zwischen dem Einlass und dem Einlassrohr auf eine einfache und kostengünstige Weise hergestellt und montiert werden kann, ohne zusätzliche Bauteile zu benötigen.

Diese Aufgabe wird durch den erfindungsgemäßen Steuerschrank für eine Abgasmessanlage nach Anspruch 1 gelöst.

Dadurch, dass der Auslass oder der Einlass in einer Anschlussebene ausgebildet ist, welche mit einer Horizontalebene einen Winkel von 45° einschließt, und das erste oder zweite Anschlusselement winkelrohrartig ausgeführt ist, wobei das winkelrohrartige erste oder zweite Anschlusselement durch eine 180°-Drehung in der Anschlussebene in der ersten Anschlussstellung und in der zweiten Anschlussstellung montierbar ist, kann der Steuerschrank unabhängig von der Lage und der Ausrichtung des Auslassrohrs oder des Einlassrohrs positioniert werden, wobei ein einziger Auslass oder Einlass vorgesehen ist, welcher je nach Lage und Ausrichtung des Auslassrohrs oder des Einlassrohrs über das winkelrohrartige Anschlusselement und durch die entsprechende Montage des Anschlusselementes in der ersten Anschlussstellung oder in der zweiten Anschlussstellung mit dem Auslassrohr oder dem Einlassrohr verbunden werden kann.

Durch eine derartige Ausgestaltung des Auslasses oder des Einlasses und des Anschlusselements wird eine einfache und kostengünstige Verbindung zwischen dem Auslass und dem Auslassrohr oder zwischen dem Einlass und dem Einlassrohr hergestellt, wobei für die Verstellung zwischen der ersten und der zweiten Anschlussstellung das Anschlusselement lediglich um 180° verdreht werden muss.

Vorzugsweise sind das erste und das zweite Anschlusselement wahlweise in einer ersten Anschlussstellung oder in einer zweiten Anschlussstellung montierbar, derart, dass das an das erste Anschlusselement anschließende Einlassrohr und das an das zweite Anschlusselement anschließende Auslassrohr in der ersten Anschlussstellung horizontal und in der zweiten Anschlussstellung vertikal ausgerichtet sind, wobei der Auslass und der Einlass in jeweils einer Anschlussebene ausgebildet sind, wobei die Anschlussebenen mit einer Horizontalebene einen Winkel von 45° einschließen, und das erste und zweite Anschlusselement winkelrohrartig ausgeführt sind, wobei das winkelrohrartige erste und zweite Anschlusselement durch eine 180°-Drehung in der jeweiligen Anschlussebene in der ersten Anschlussstellung und in der zweiten Anschlussstellung montierbar sind. Dadurch können der Einlass bei einer vorgegebenen Lage und Ausrichtung des Einlassrohrs mit dem Einlassrohr und der Auslass bei einer vorgegebenen Lage und Ausrichtung des Auslassrohrs mit dem Auslassrohr auf eine einfache und kostengünstige Weise verbunden werden.

Vorzugsweise weist die Komponente der Abgasmessanlage, insbesondere des Abgasverdünnungssystems, mehrere Durchflussrohre auf, welche in einem Sammeleinlass und in einem Sammelauslass münden, wobei am Sammelauslass der Auslass ausgebildet ist und am Sammeleinlass der Einlass ausgebildet ist. Die Durchflussrohre weisen üblicherweise jeweils ein Stellventil auf, so dass durch das Betätigen der Stellventile einzelne Durchflussrohre zu Messzwecken abgesperrt oder geöffnet werden können. Durch das Vorsehen des Sammeleinlasses und des Sammelauslasses erfolgen die Zuführung und die Abführung des in den Durchflussrohren strömenden Gases kostensparend und bauraumsparend lediglich durch jeweils eine einzige Komponente.

Vorzugsweise sind der Sammelauslass und/oder der Sammeleinlass mit zwei gegenüberliegenden Anschlussebenen ausgeführt, wobei eine erste Anschlussebene und eine zweite Anschlussebene jeweils einen Winkel von 45° mit der Horizontalebene einschließen und die Anschlussebenen senkrecht zueinander angeordnet sind. Dadurch kann das Anschlusselement zum einen in der ersten sowie in der zweiten Anschlussstellung und zum anderen in der ersten sowie in der zweiten Anschlussebene montiert werden. Dadurch kann das Anschlusselement in vier unterschiedlichen Anschlussstellungen angeordnet werden, wodurch die Flexibilität bei der Positionierung des Steuerschranks erhöht wird.

Vorzugsweise weist das erste Anschlusselement und/oder das zweite Anschlusselement mindestens einen mit dem Sammeleinlass oder dem Sammelauslass verbundenen ersten Abschnitt und mindestens einen an dem ersten Abschnitt anschließenden zweiten Abschnitt auf, wobei eine Wand des ersten Abschnitts, eine Wand des zweiten Abschnitts und eine Wand des Sammelauslasses und/oder des Sammeleinlasses jeweils einen Winkel mit einer Längsachse des Anschlusselements einschließen, wobei in der ersten Anschlussstellung des Anschlusselements der Winkel der Wand des Sammelauslasses oder des Sammeleinlasses zur horizontalen Längsachse größer als der Winkel der Wand des ersten Abschnitts ist und der Winkel der Wand des ersten Abschnitts zur horizontalen Längsachse größer als der Winkel der Wand des zweiten Abschnitts ist, derart, dass eine kurvenartige Strömungsumlenkung erfolgt. Dadurch kann das strömende Gas im Sammeleinlass und in dem ersten Anschlusselement oder in dem Sammelauslass und dem zweiten Anschlusselement derart umgelenkt werden, dass ein Totvolumen verhindert wird und die Strömungsverluste reduziert werden.

In einer vorteilhaften Ausgestaltung ist die Komponente der Abgasmessanlage um 180° um eine Horizontalachse verdrehbar, wobei der Auslass in einer ersten Stellung dem Deckelelement zugewandt ist und in einer zweiten Stellung dem Bodenelement zugewandt ist. Dadurch kann die Lage des Einlasses und des Auslasses an die Lage des Einlassrohrs und des Auslassrohrs auf eine einfache und kostengünstige Weise angepasst werden.

Vorzugsweise ist die Komponente der Abgasmessanlage eine Durchflussregelvorrichtung einer CVS-Anlage, wobei über das Einlassrohr ein Verdünnungstunnel mit der Durchflussregelvorrichtung verbunden ist. In der CVS-Anlage werden die von einem Kraftfahrzeug und während einem vorgegebenen Fahrzyklus emittierten Abgase zunächst mit Luft verdünnt, die verdünnten Abgase in einem Abgasbeutel gesammelt und die in dem Abgasbeutel gesammelten, verdünnten Abgase mittels Analysegeräte bezüglich der im Abgas enthaltenen Schadstoffe analysiert. Im Verdünnungstunnel werden die Abgase zu Messzwecken mit Luft verdünnt, wobei der Verdünnungstunnel durch das Einlassrohr ausgebildet ist oder durch das Einlassrohr mit der Durchflussregelvorrichtung verbunden ist.

In einer bevorzugten Ausgestaltung ist die Komponente der Abgasmessanlage eine Durchflussregelvorrichtung einer CVS-Anlage, wobei über das Auslassrohr ein Gebläse mit der Durchflussregelvorrichtung verbunden ist. Durch das Gebläse wird der durch die Durchflussregelvorrichtung strömende Volumenstrom erzeugt.

Es wird somit ein Steuerschrank für eine Abgasmessanlage bereitgestellt, welcher unabhängig von der Lage und der Ausrichtung des Auslassrohrs aufgestellt werden kann, wobei hierfür die Verbindung zwischen dem Auslass und dem Auslassrohr auf eine einfache und kostengünstige Weise ausgestaltet ist.

Nachfolgend wird die Erfindung anhand einer bevorzugten Ausführung unter Bezugnahme auf die anliegende Zeichnung näher erläutert.

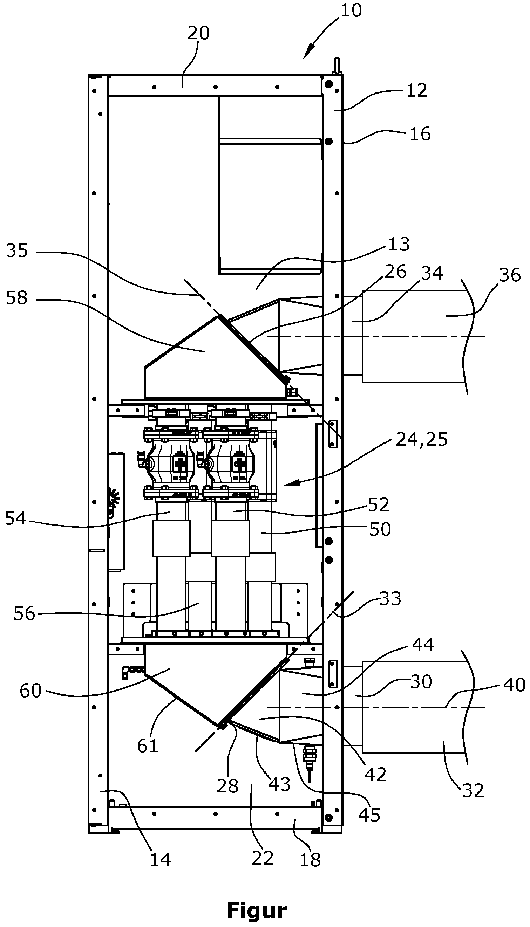

Figur 1 zeigt schematisch einen erfindungsgemäßen Steuerschrank für eine Abgasmessanlage.

Der Steuerschrank 10 besteht aus einem Schrankkörper 12, welcher eine erste Seitenwand 14, eine gegenüberliegende zweite Seitenwand 16, ein Bodenelement 18, ein Deckenelement 20 sowie eine Rückwand 22 aufweist. An der zur Rückwand 22 gegenüberliegenden Seite ist eine in der Figur nicht dargestellte Tür angeordnet, über welche in einer geöffneten Stellung ein Eingriff in einen Innenraum 13 des Schrankkörpers 12 ermöglicht wird. Im Innenraum 13 des Schrankkörpers 12 ist eine Komponente 24 einer Abgasmessanlage angeordnet.

Die Komponente 24 der Abgasmessanlage ist eine Durchflussregelvorrichtung 25 einer CVS-Anlage, wobei bei einer CVS-Anlage während eines Testzyklus das von einem Kraftfahrzeug ausgestoßene Abgas in einen Verdünnungstunnel eingeleitet und darin mit Luft verdünnt wird. Anschließend wird das verdünnte Abgas in die Durchflussregelvorrichtung 25 eingeleitet. In der Durchflussregelvorrichtung 25 wird ein konstanter und für die Messung erforderlicher Volumenstrom des verdünnten Abgases eingestellt, bevor das verdünnte Abgas durch Probeentnahmesonden entnommen und einem oder mehreren Abgasbeuteln zugeführt wird. Nach Abschluss des Fahrzykluses wird das in dem Abgasbeutel gesammelte verdünnte Abgas bezüglich der Schadstoffanteile durch mehrere Analysegeräte analysiert, wobei insbesondere der Kohlendioxid-, der Kohlenmonoxid-, Kohlenwasserstoffsowie der Stickoxid-Anteil ermittelt werden.

Die Durchflussregelvorrichtung 25 weist vier Durchflussrohre 50, 52, 54, 56 auf, welche mit einem ersten axialen Ende in einem Sammeleinlass 58 und mit dem entgegengesetzten, zweiten axialen Ende in einem Sammelauslass 60 münden. Zum Einstellen des konstanten Volumenstroms und zum Einstellen der Höhe der Verdünnung weist jedes Durchflussrohr 50, 52, 54, 56 jeweils eine im überkritischen Bereich betriebene Venturidüse und jeweils ein Stellventil auf.

Der Sammelauslass 60 weist vier Öffnungen auf, durch die die vier Durchflussrohre 50, 52, 54, 56 in den Sammelauslass 60 hineingeführt sind. Außerdem ist am Sammelauslass 60 der Auslass 28 der Durchflussregelvorrichtung 25 ausgebildet, wobei der Auslass 28 über ein erstes Anschlusselement 30, welches in einer Anschlussebene 33 mit dem Auslass 28 verbunden ist, mit einem Auslassrohr 32 fluidisch verbunden ist. An das Auslassrohr 32 ist ein nicht dargestelltes Gebläse zum Erzeugen einer Strömung durch die Durchflussregelvorrichtung 25 angeschlossen.

Erfindungsgemäß schließt die Anschlussebene 33 einen Winkel von 45° mit der Horizontalebene ein und das erste Anschlusselement 30 ist winkelrohrartig ausgebildet, wobei das erste Anschlusselement 30 in einer ersten und einer zweiten Anschlussstellungen montiert werden kann.

Zum Verstellen des ersten Anschlusselements 30 von der ersten Anschlussstellung in die zweite Anschlussstellung wird das erste Anschlusselement 30 in der Anschlussebene 33 um 180° gedreht.

In der ersten Anschlussstellung 30, wie es in der Figur 1 gezeigt ist, ist das erste Anschlusselement 30 derart ausgerichtet, dass das erste Anschlusselement 30 mit einem horizontal ausgerichteten Auslassrohr 32 verbunden werden kann. Dabei durchdringt das erste Anschlusselement 30 die zweite Seitenwand 16, so dass das erste Anschlusselement 30 außerhalb vom Schrankkörper 12 mit dem Auslassrohr 32 verbunden wird. Anderenfalls kann das an das erste Anschlusselement 30 anschließende Auslassrohr 32 vertikal verlaufen. Hierbei wird das erste Anschlusselement 30 in der in der Figur 1 nicht dargestellten, zweiten Anschlussstellung montiert, wobei das erste Anschlusselement 30 das Bodenelement 18 durchdringt und unterhalb des Schrankkörpers 12 mit dem Auslassrohr 32 verbunden wird.

Für eine verlust- und störungsarme Strömung durch den Sammelauslass 60 und das erste Anschlusselement 30 weist das erste Anschlusselement 30 einen mit dem Auslass 28 verbundenen ersten Abschnitt 42 und einen an dem ersten Abschnitt anschließenden zweiten Abschnitt 44 auf, wobei eine Wand 43 des ersten Abschnitts 42, eine Wand 45 des zweiten Abschnitts 44 und eine Wand 61 des Sammelauslasses 60 jeweils einen Winkel mit einer Längsachse 40 des ersten Anschlusselements 30 einschließen. Der Winkel sinkt stromabwärts ausgehend von der Wand 61 des Sammelauslasses 60 bis zur Wand 43 des zweiten Abschnitts 44 derart ab, dass eine kurvenartige Strömungsumlenkung des aus der Durchflussregelvorrichtung 25 ausströmenden Gases erfolgt. In der zweiten Anschlussstellung des ersten Anschlusselements 30 strömt das aus der Durchflussregelvorrichtung 25 ausströmende Gases parallel zur Durchströmung der Durchflussregelvorrichtung 25 aus dem ersten Anschlusselement 30 aus, so dass keine 90° Strömungsumlenkung entsteht.

Der Sammeleinlass 58 ist in gleicher Weise wie der Sammelauslass 60 ausgebildet, wobei der Sammeleinlass 58 den Einlass 26 aufweist. Der Einlass 26 ist über ein zweites Anschlusselement 34, welches in einer Anschlussebene 35 mit dem Einlass 26 gekoppelt ist, mit einem Einlassrohr 36 fluidisch verbunden, wobei das zweite Anschlusselement 34 in einer ersten Anschlussstellung und in einer zweiten Anschlussstellung montiert werden kann und dadurch mit dem vertikal oder horizontal ausgerichteten Einlassrohr 36 gekoppelt werden kann. Das Einlassrohr 36 bildet einen Verdünnungstunnel der CVS-Anlage. Alternativ dient das Einlassrohr 36 als ein Verbindungsrohr zwischen dem Verdünnungstunnel und dem zweiten Anschlusselement 34.

In der in Figur 1 gezeigten Ausgestaltung ist das Auslassrohr 32 im oberen Bereich des Schrankkörpers 12 und das Einlassrohr 36 im unteren Bereich des Schrankkörpers 12 angeordnet, so dass die Durchflussregelvorrichtung 25 derart im Schrankkörper 12 ausgerichtet ist, dass der Einlass 26 dem Deckenelement 20 zugewandt ist und der Auslass 28 dem Bodenelement 18 zugewandt ist. Alternativ könnte der Einlass 26 dem Bodenelement 18 zugewandt sein und der Auslass 28 dem Deckenelement 20 zugewandt sein, wobei hierfür die Durchflussregelvorrichtung 25 um 180° um eine Horizontalachse gedreht wird.

Somit wird ein Steuerschrank für eine Abgasmessanlage bereitgestellt, welcher unabhängig von der Lage und der Ausrichtung des Auslassrohrs aufgestellt werden kann, wobei hierfür die Verbindung des Auslasses mit dem Auslassrohr auf eine einfache und kostengünstige Weise hergestellt werden kann. Zusätzlich kann durch Drehung des Sammeleinlasses oder des Sammelauslasses auch ein Anschluss an der entgegengesetzten Seitenwand erfolgen.

Es sollte deutlich sein, dass der Schutzbereich des vorliegenden Hauptanspruchs nicht auf das beschriebene Ausführungsbeispiel des Steuerschranks begrenzt ist. Es können beispielsweise das Anschlusselement oder der Sammelauslass anders ausgeführt sein. Außerdem könnte beispielsweise eine andere Komponente der Abgasmessanlage, beispielsweise ein Wärmetauscher, in dem Steuerschrank angeordnet sein.

## Patentansprüche

1. Steuerschrank für eine Abgasmessanlage mit
einem Schrankkörper (12), in dem eine Komponente (24) der Abgasmessanlage mit einem innerhalb des Schrankkörpers (12) angeordneten Einlass (26) und einem innerhalb des Schrankkörpers (12) angeordneten Auslass (28) angeordnet ist, wobei der Auslass (28) über ein erstes Anschlusselement (30) mit einem Auslassrohr (32) und der Einlass (26) über ein zweites Anschlusselement (34) mit einem Einlassrohr (36) verbunden sind, wobei das erste oder das zweite Anschlusselement (30, 34) wahlweise in einer ersten Anschlussstellung oder in einer zweiten Anschlussstellung montierbar ist, derart, dass das an das erste oder zweite Anschlusselement (30, 34) anschließende Auslassrohr (32) oder Einlassrohr (36) in der ersten Anschlussstellung horizontal und in der zweiten Anschlussstellung vertikal ausgerichtet ist,
**dadurch gekennzeichnet, dass**
der Auslass (28) oder der Einlass (26) in einer Anschlussebene (33, 35) ausgebildet ist, welche mit einer Horizontalebene einen Winkel von 45° einschließt, und das erste oder zweite Anschlusselement (30, 34) winkelrohrartig ausgeführt ist, wobei das winkelrohrartige erste oder zweite Anschlusselement (30, 34) durch eine 180°-Drehung in der Anschlussebene (33, 35) in der ersten Anschlussstellung und in der zweiten Anschlussstellung montierbar ist.

2. Steuerschrank nach Anspruch 1,
**dadurch gekennzeichnet, dass**
das erste und das zweite Anschlusselement (30, 34) wahlweise in einer ersten Anschlussstellung oder in einer zweiten Anschlussstellung montierbar sind, derart, dass das an das erste Anschlusselement (32) anschließende Einlassrohr (36) und das an das zweite Anschlusselement (30, 34) anschließende Auslassrohr (32) in der ersten Anschlussstellung horizontal und in der zweiten Anschlussstellung vertikal ausgerichtet sind, wobei der Auslass (28) und der Einlass (26) in jeweils einer Anschlussebene (33, 35) ausgebildet sind, wobei die Anschlussebenen mit einer Horizontalebene einen Winkel von 45° einschließen, und das erste und zweite Anschlusselement (30, 34) winkelrohrartig ausgeführt sind, wobei das winkelrohrartige erste und zweite Anschlusselement (30, 34) durch eine 180°-Drehung in der jeweiligen Anschlussebene (33, 35) in der ersten Anschlussstellung und in der zweiten Anschlussstellung montierbar sind.

3. Steuerschrank nach Anspruch 1 oder 2,
**dadurch gekennzeichnet, dass**
die Komponente (24) der Abgasmessanlage mehrere Durchflussrohre (50, 52, 54, 56) aufweist, welche in einem Sammeleinlass (58) und in einem Sammelauslass (60) münden, wobei am Sammelauslass (60) der Auslass (28) ausgebildet ist und am Sammeleinlass (58) der Einlass (26) ausgebildet ist.

4. Steuerschrank nach Anspruch 3,
**dadurch gekennzeichnet, dass**
der Sammelauslass (60) und/oder der Sammeleinlass (58) mit zwei gegenüberliegenden Anschlussebenen ausgeführt sind, wobei eine erste Anschlussebene und eine zweite Anschlussebene jeweils einen Winkel von 45° mit der Horizontalebene einschließen und die Anschlussebenen senkrecht zueinander angeordnet sind.

5. Steuerschrank nach Anspruch 3 oder 4,
**dadurch gekennzeichnet, dass**
das erste Anschlusselement (30) und/oder das zweite Anschlusselement (34) mindestens einen mit dem Sammeleinlass (58) oder dem Sammelauslass (60) verbundenen ersten Abschnitt (42) und mindestens einen an dem ersten Abschnitt anschließenden zweiten Abschnitt (44) aufweist, wobei eine Wand (43) des ersten Abschnitts (42), eine Wand (45) des zweiten Abschnitts (44) und eine Wand (61) des Sammelauslasses (60) und/oder des Sammeleinlasses (58) jeweils einen Winkel mit einer Längsachse (40) des Anschlusselements (30, 34) einschließen, wobei in der ersten Anschlussstellung des Anschlusselements (30, 34) der Winkel der Wand (61) des Sammelauslasses (60) oder des Sammeleinlasses (58) zur horizontalen Längsachse (40) größer als der Winkel der Wand (43) des ersten Abschnitts (42) ist und der Winkel der Wand (43) des ersten Abschnitts (42) zur horizontalen Längsachse (40) größer als der Winkel der Wand (45) des zweiten Abschnitts (44) ist, derart, dass eine kurvenartige Strömungsumlenkung erfolgt.

6. Steuerschrank nach einem der vorhergehenden Ansprüche,
**dadurch gekennzeichnet, dass**
die Komponente (24) der Abgasmessanlage um 180° um eine Horizontalachse verdrehbar ist, wobei in einer ersten Stellung der Auslass dem Deckelelement (20) zugewandt ist und in einer zweiten Stellung dem Bodenelement (18) zugewandt ist.

7. Steuerschrank nach einem der vorhergehenden Ansprüche,
**dadurch gekennzeichnet, dass**
die Komponente (24) der Abgasmessanlage eine Durchflussregelvorrichtung (25) einer CVS-Anlage ist, wobei über das Einlassrohr (36) ein Verdünnungstunnel mit der Durchflussregelvorrichtung (25) verbunden ist.

8. Steuerschrank nach einem der vorhergehenden Ansprüche,
**dadurch gekennzeichnet, dass**
die Komponente (24) der Abgasmessanlage eine Durchflussregelvorrichtung (25) einer CVS-Anlage ist, wobei über das Auslassrohr (32) ein Gebläse mit der Durchflussregelvorrichtung (25) verbunden ist.

## Claims

1. Control cabinet for an exhaust gas measuring system with a cabinet body (12) in which a component (24) of the exhaust gas measuring system is arranged with an inlet (26) arranged within the cabinet body (12) and an outlet (28) arranged within the cabinet body (12), wherein the outlet (28) is connected to an outlet tube (32) via a first connection element (30) and the inlet (26) is connected to an inlet tube (36) via a second connection element (34) wherein the first or the second connection element (30, 34) can be mounted selectively in a first connection position or in a second connection position in such a way that the outlet tube (32) or inlet tube (36) adjoining the first or second connection element (30, 34) is aligned horizontally in the first connection position and vertically in the second connection position,
**characterised in that**
the outlet (28) or the inlet (26) is configured in a connection plane (33, 35) which encloses an angle of 45° with a horizontal plane, and the first or second connection element (30, 34) is configured in the manner of an angled tube, wherein the first or second connection element (30, 34) in the manner of an angled tube can be mounted (33, 35) in the first connection position and in the second connection position by a 180° rotation in the connection plane.

2. Control cabinet according to claim 1,
**characterized in that**
the first and second connection element (30, 34) are selectively mountable in a first connection position or in a second connection position in such a way that the inlet tube (36) adjoining the first connection element (32) and the outlet tube (32) adjoining the second connection element (30, 34) are aligned horizontally in the first connection position and vertically in the second connection position, wherein the outlet (28) and the inlet (26) are configured in a respective connection plane (33, 35), wherein the connection planes enclose an angle of 45° with a horizontal plane, and the first and second connection elements (30, 34) are configured in the manner of angled tubes, wherein the angled-tube-like first and second connection elements (30, 34) are mountable in the first connection position and in the second connection position by a 180° rotation in the respective connection plane (33, 35).

3. Control cabinet according to claim 1 or 2,
**characterised in that**
the component (24) of the exhaust gas measuring system comprises a plurality of through-flow pipes (50, 52, 54, 56) which lead into a collecting inlet (58) and into a collecting outlet (60), wherein the outlet (28) is configured at the collecting outlet (60) and the inlet (26) is configured at the collecting inlet (58).

4. Control cabinet according to claim 3,
**characterised in that**
the collecting outlet (60) and/or the collecting inlet (58) are configured with two opposite connection planes, wherein a first connection plane and a second connection plane respectively enclose an angle of 45° with the horizontal plane and the connection planes are arranged perpendicular to one another.

5. Control cabinet according to claim 3 or 4,
**characterised in that**
the first connection element (30) and/or the second connection element (34) comprises at least one first section (42) connected to the collective inlet (58) or the collective outlet (60) and at least one second section (44) adjoining the first section, wherein a wall (43) of the first section (42), a wall (45) of the second section (44) and a wall (61) of the collection outlet (60) and/or of the collection inlet (58) respectively enclose an angle with a longitudinal axis (40) of the connection element (30, 34), wherein in the first connection position of the connection element (30, 34) the angle of the wall (61) of the collecting outlet (60) or of the collecting inlet (58) relative to the horizontal longitudinal axis (40) is greater than the angle of the wall (43) of the first section (42) and the angle of the wall (43) of the first section (42) relative to the horizontal longitudinal axis (40) is larger than the angle of the wall (45) of the second section (44), in such a way that a curve-like flow deflection takes place.

6. Control cabinet according to one of the preceding claims,
**characterised in that**
the component (24) of the exhaust gas measuring system is rotatable by 180° about a horizontal axis, wherein in a first position the outlet faces the cover element (20) and in a second position it faces the bottom element (18).

7. Control cabinet according to one of the preceding claims,
**characterized in that**
the component (24) of the exhaust gas measuring system is a flow control device (25) of a CVS system, wherein a dilution tunnel is connected to the flow control device (25) via the inlet pipe (36).

8. Control cabinet according to one of the preceding claims,
**characterized in that**
the component (24) of the exhaust gas measurement system is a flow control device (25) of a CVS system, wherein a blower is connected to the flow control device (25) via the outlet tube (32).

## Revendications

1. Cabinet de contrôle pour un système de mesure des gaz d'échappement avec
un corps de cabinet (12) dans lequel est disposé un composant (24) de système de mesure des gaz d'échappement avec une entrée (26) disposée à l'intérieur du corps de cabinet (12) et une sortie (28) disposée à l'intérieur du corps de cabinet (12), la sortie (28) étant reliée à un tube de sortie (32) par un premier élément de raccordement (30) et l'entrée (26) à un tube d'entrée (36) par un deuxième élément de raccordement (34), le premier ou le deuxième élément de raccordement (30, 34) peut être monté au choix dans une première position de raccordement ou dans une deuxième position de raccordement, de telle sorte que le tube de sortie (32) ou le tube d'entrée (36) raccordé au premier ou au deuxième élément de raccordement (30, 34) est orienté horizontalement dans la première position de raccordement et verticalement dans la deuxième position de raccordement,
**caractérisé en ce que**
la sortie (28) ou l'entrée (26) est réalisée dans un plan de raccordement (33, 35) qui forme un angle de 45° avec un plan horizontal, et le premier ou le deuxième élément de raccordement (30, 34) est réalisé sous forme de tube angulaire, le premier ou le deuxième élément de raccordement (30, 34) sous forme de tube angulaire peut être monté dans la première position de raccordement et dans la deuxième position de raccordement par une rotation de 180° dans le plan de raccordement (33, 35).

2. Cabinet de commande selon la revendication 1,
**caractérisé en ce que**
le premier et le deuxième élément de raccordement (30, 34) peuvent être montés au choix dans une première position de raccordement ou dans une deuxième position de raccordement, de telle sorte que le tube d'entrée (36) raccordé au premier élément de raccordement (32) et le tube de sortie (32) raccordé au deuxième élément de raccordement (30, 34) sont orientés horizontalement dans la première position de raccordement et verticalement dans la deuxième position de raccordement, la sortie (28) et l'entrée (26) étant formées chacune dans un plan de raccordement (33, 35), les plans de raccordement formant un angle de 45° avec un plan horizontal, et le premier et le deuxième élément de raccordement (30, 34) étant réalisés sous forme de tube angulaire, le premier et le deuxième élément de raccordement (30, 34) sous forme de tube angulaire pouvant être montés dans la première position de raccordement et dans la deuxième position de raccordement par une rotation de 180° dans le plan de raccordement respectif (33, 35).

3. Cabinet de contrôle selon la revendication 1 ou 2,
**caractérisé en ce que**
le composant (24) de système de mesure des gaz d'échappement comprend plusieurs tubes d'écoulement (50, 52, 54, 56) qui débouchent dans une entrée de collecte (58) et dans une sortie de collecte (60), la sortie (28) est formée sur la sortie de collecte (60) et l'entrée (26) est formée sur l'entrée de collecte (58).

4. Cabinet de contrôle selon la revendication 3,
**caractérisé en ce que**
la sortie de collecte (60) et/ou l'entrée de collecte (58) sont réalisées avec deux plans de raccordement opposés, un premier plan de raccordement et un deuxième plan de raccordement formant chacun un angle de 45° avec le plan horizontal et les plans de raccordement étant disposés perpendiculairement l'un à l'autre.

5. Cabinet de contrôle selon la revendication 3 ou 4,
**caractérisé en ce que**
le premier élément de raccordement (30) et/ou le deuxième élément de raccordement (34) comprend au moins une première section (42) reliée à l'entrée de collecte (58) ou à la sortie de collecte (60) et au moins une deuxième section (44) se raccordant à la première section, dans lequel une paroi (43) de la première section (42), une paroi (45) de la deuxième section (44) et une paroi (61) de la sortie de collecte (60) et/ou de l'entrée de collecte (58) forment chacune un angle avec un axe longitudinal (40) de l'élément de raccordement (30, 34), l'angle de la paroi (61) de la sortie de collecte (60) ou de l'entrée de collecte (58) par rapport à l'axe longitudinal horizontal (40) étant, dans la première position de raccordement de l'élément de raccordement (30, 34), plus grand que l'angle de la paroi (43) de la première section (42) et l'angle de la paroi (43) de la première section (42) par rapport à l'axe longitudinal horizontal (40) est plus grand que l'angle de la paroi (45) de la deuxième section (44), de sorte qu'il se forme une déviation d'écoulement curviligne.

6. Cabinet de contrôle selon l'une quelconque des revendications précédentes,
**caractérisé en ce que**
le composant (24) de système de mesure des gaz d'échappement peut être tourné de 180° autour d'un axe horizontal, la sortie fait face à l'élément de plafond (20) dans une première position et fait face à l'élément de fond (18) dans une deuxième position.

7. Cabinet de contrôle selon l'une quelconque des revendications précédentes,
**caractérisé en ce que**
le composant (24) de système de mesure des gaz d'échappement est un dispositif de régulation de flux (25) d'une installation CVS, un tunnel de réduction étant relié au dispositif de régulation de flux (25) via le tube d'entrée (36).

8. Cabinet de contrôle selon l'une quelconque des revendications précédentes,
**caractérisé en ce que**
le composant (24) de système de mesure des gaz d'échappement est un dispositif de régulation de flux (25) d'une installation CVS, un ventilateur est relié au dispositif de régulation de flux (25) via le tube de sortie (32).
